# EUROPÄISCHE PATENTSCHRIFT

(11) **EP 2 285 495 B1**
(45) Veröffentlichungstag und Bekanntmachung des Hinweises auf die Patenterteilung: **30.03.2016**
(21) Anmeldenummer: 09761513.2
(22) Anmeldetag: 12.06.2009
(51) Int. Cl.: B05B 5/04

(54) **UNIVERSALZERSTÄUBER**
UNIVERSAL ATOMIZER
PULVÉRISATEUR UNIVERSEL

(30) Priorität: 12.06.2008 DE 102008027997
(43) Veröffentlichungstag der Anmeldung: 23.02.2011
(73) Patentinhaber: Dürr Systems GmbH, 74321 Bietigheim-Bissingen (DE)
(72) Erfinder: FISCHER, Andreas, 71636 Ludwigsburg (DE); MARQUARDT, Peter, 71711 Steinheim (DE); NOLTE, Hans-Jürgen, 74354 Besigheim (DE); BERKOWITSCH, Jürgen, 73765 Neuhausen (DE)
(74) Vertreter: Beier, Ralph
(86) Internationale Anmeldenummer: PCT/EP2009/004254
(87) Internationale Veröffentlichungsnummer: WO 2009/149950

(56) Entgegenhaltungen:
- EP-A1- 1 923 138
- WO-A1-2008/061584
- WO-A1-2008/068005
- DE-A1-102005 015 604
- JP-A- 8 099 052
- DÜRR SYSTEMS GMBH: "STATION 1, ECOBELL2" DÜRR - OPEN HOUSE 2007, 24. Juli 2007 (2007-07-24), XP002546471 Bietigheim-Bissingen
- Anonym: "Hochgeschwindigkeits-Rotationszerstäuber EcoBell2 für Direktaufladung" www.durr.com Dürr Produktinfo 10. Februar 2008 (2008-02-10), XP002546472 Gefunden im Internet: URL:http://web.archive.org/web/20071020111 843/www.durr.com/fileadmin/user_upload/apt /de/pdf/Produktinfo/EcoBell2_DE_02.pdf> [gefunden am 2009-09-17]

## Beschreibung

Die Erfindung betrifft ein Zerstäubungssystem für einen Rotationszerstäuber.

In modernen Lackieranlagen zur Lackierung von Kraftfahrzeugkarosserien sind meist - mit Ausnahme des sogenannten Boxenkonzepts - entlang einer Lackierstraße hintereinander mehrere Lackierkabinen angeordnet, in denen Lackierroboter verschiedene Lackierarbeiten ausführen. So kann beispielsweise in einer ersten Lackierkabine der Innenraum der einzelnen Kraftfahrzeugkarosserien mit einer Grundierung ("Primer") beschichtet werden. In der nächsten Lackierkabine können dann die Außenflächen der Kraftfahrzeugkarosserie mit der Grundierung beschichtet werden. Anschließend folgt dann ein Trockner, in dem die auf die Kraftfahrzeugkarosserie aufgebrachte Grundierungsschicht trocknet, bevor dann in einer weiteren Lackierkabine ein Basislack ("Base Coat") auf die Innenflächen der Kraftfahrzeugkarosserie appliziert wird. Die Außenflächen der Kraftfahrzeugkarosserien werden dann in zwei aufeinanderfolgenden Lackierkabinen nacheinander ("Nass in nass") mit zwei Basislackschichten beschichtet. Alternativ besteht jedoch auch die Möglichkeit, dass zuerst die Außenflächen und dann die Innenflächen mit dem Basislack beschichtet werden. Nach dem Auftrag der Basislackschichten wird dann in zwei aufeinanderfolgenden Lackierkabinen ein Klarlack ("Clear Coat") zunächst auf die Innenflächen und dann auf die Außenflächen der Kraftfahrzeugkarosserie aufgebracht. Schließlich wird die auf diese Weise lackierte Kraftfahrzeugkarosserie dann in einem Trockner getrocknet. Darüber hinaus gibt es einen sogenannten 3-Wet-Prozess, bei dem die vorstehend erwähnten Trocknungsschritte entfallen können.

Die Beschichtung der Kraftfahrzeugkarosserie mit den verschiedenen Beschichtungsmitteln (Grundierung, Basislack, Klarlack) in den aufeinander folgenden Lackierkabinen erfolgt üblicherweise durch mehrachsige Lackierroboter oder Lackiermaschinen (z.B. Dachmaschinen, Seitenmaschinen), die als Applikationsgerät einen Rotationszerstäuber aufweisen, wobei die Rotationszerstäuber in den verschiedenen Lackierkabinen an das verwendete Beschichtungsmittel und an die anfallende Lackierarbeit angepasst sind. So werden beispielsweise zur Innenlackierung Rotationszerstäuber mit einem anderen Glockenteller eingesetzt als bei der Außenlackierung. Dies hat zur Folge, dass zur vollständigen Lackierung einer Kraftfahrzeugkarosserie mehrere Lackierkabinen mit unterschiedlichen Rotationszerstäubern und der zugehörigen Applikationstechnik erforderlich sind, was mit einem hohen anlagentechnischen Aufwand verbunden ist.

Ein weiterer Nachteil der individuellen Anpassung der Rotationszerstäuber an die jeweiligen Lackierarbeiten (Innenlackierung, Außenlackierung bzw. Metalliclackierung) liegt in den hohen Betriebskosten und der aufwändigen Lagerhaltung.

Das gleiche Problem stellt sich auch bei Beschichtungen in der allgemeinen Industrie und in der Automobilzulieferindustrie, wo Anbauteile (z.B. Stoßfänger, Tankdeckel, Spiegelgehäuse, etc.) lackiert werden.

Ferner ist zum Stand der Technik hinzuweisen auf WO 2008/068005 A, DE 10 2005 015604 A1, EP 1 923 138 A und WO 2008/061584 A sowie auf die Veröffentlichung "Hochgeschwindigkeits-Rotationszerstäuber EcoBell2 für Direktaufladung" der Anmelderin.

Schließlich offenbaren JP 08 099052 A und die Veröffentlichung der Anmelderin mit dem Titel "STATION 1, ECOBELL2" zu ihrem "OPEN HOUSE 2007" ein Zerstäubungssystem gemäß dem Oberbegriff des Hauptanspruchs.

Der Erfindung liegt deshalb die Aufgabe zugrunde, den anlagentechnischen Aufwand bei der Lackierung von Kraftfahrzeugkarosserien zu verringern.

Diese Aufgabe wird durch ein erfindungsgemäßes Zerstäubersystem gemäß Anspruch 1 gelöst.

Die Erfindung umfasst die allgemeine technische Lehre, mit einem einzigen Zerstäubungssystem in einer einzigen Lackierkabine bzw. Lackierzone die verschiedenen Lackierarbeiten (z.B. Innenlackierung und Außenlackierung) beim Lackieren von Kraftfahrzeugkarosserien durchzuführen, wodurch der anlagentechnische Aufwand stark verringert wird, da auf die im Stand der Technik erforderlichen zusätzlichen Lackierkabinen verzichtet werden kann.

Ein weiterer Vorteil der Erfindung ist die größere Flexibilität, da ein einziges Zerstäubungssystem nacheinander verschiedene Lackierarbeiten (z.B. Innenlackierung und Außenlackierung) durchführen kann.

Die Erfindung sieht also ein Zerstäubungssystem für einen Rotationszerstäuber vor, das sich sowohl zur Innenlackierung als auch zur Außenlackierung von Kraftfahrzeugkarosseriebauteilen eignet.

Darüber hinaus eignet sich das erfindungsgemäße Zerstäubungssystem vorzugsweise auch zur Applikation eines Metalliclacks oder eines sonstigen Effektlacks.

Weiterhin eignet sich das erfindungsgemäße, universell einsetzbare Zerstäubungssystem vorzugsweise auch zur Applikation verschiedener Beschichtungsmittel, wie beispielsweise Füller, Basislack und Klarlack.

Ferner eignet sich das erfindungsgemäße Zerstäubungssystem vorzugsweise auch zur Applikation verschiedener Lacksysteme, wie beispielsweise von Lösemittellacken oder Wasserlacken.

Darüber hinaus eignet sich das erfindungsgemäße Zerstäubungssystem vorzugsweise sowohl zur elektrostatischen Lackierung als auch zur Lackierung ohne Hochspannung.

Das erfindungsgemäße, universell verwendbare Zerstäubungssystem funktioniert bei den vorstehend erwähnten Lackierarbeiten zumindest genau so gut oder sogar besser wie die spezifisch angepassten Zerstäubungssysteme, die bisher zum Einsatz kamen.

Ein weiterer Vorteil des erfindungsgemäßen, universell einsetzbaren Zerstäubungssystem besteht darin, dass die im Stand der Technik bestehende Vertauschungsgefahr ausgeschlossen ist.

Hierbei ermöglicht das erfindungsgemäße Zerstäubungssystem bei der Innenlackierung, bei der Außenlackierung und/oder bei der Applikation von Metalliclack bzw. Effektlack vorzugsweise einen Auftragswirkungsgrad gemäß DIN EN 13966-1 von mehr als 55%, 60%, 65%, 70%, 75%, 80% oder sogar mehr als 85%.

Darüber hinaus ermöglicht das erfindungsgemäße Zerstäubungssystem bei der Innenlackierung, der Außenlackierung und/oder bei der Applikation eines Metalliclacks oder eines sonstigen Effektlacks zur Erfüllung der üblichen Anforderungen an die Farbübereinstimmung ("Color Match") vorzugsweise einen Gesamtfarbabstand ΔE* entsprechend dem von der CIE (Commission Internationale de l'Éclairage) vorgegebenen CIELAB-Farbmodell gemäß DIN 6174 von weniger als ±3, ±2, ±1,5 oder sogar weniger als ±1, wobei vorzugsweise von einem Betrachtungswinkel im Bereich von 25°-75° ausgegangen wird. Hierbei ist zu erwähnen, dass der Gesamtfarbabstand Schwankungen aufweist, so dass vorzugsweise der Durchschnittswert zugrunde zu legen ist.

Hierzu weist das erfindungsgemäße Zerstäubungssystem einen drehbar gelagerten Glockenteller zur Zerstäubung des jeweiligen Beschichtungsmittels und zur Abgabe eines Sprühstrahls des Beschichtungsmittels auf. Der Glockenteller ist hierbei konstruktiv angepasst, damit der Glockenteller sowohl zur Innenlackierung als auch zur Außenlackierung bzw. zur Lackierung von Metallic- oder Effektlacken geeignet ist, wie noch detailliert beschrieben wird.

Darüber hinaus weist das erfindungsgemäße Zerstäubungssystem einen Lenkluftring zur Abgabe einer ersten Lenkluft und einer zweiten Lenkluft zur Formung des von dem Glockenteller abgegebenen Sprühstrahls auf, wobei die beiden Lenklüfte getrennte Lenkluftzuführungen aufweisen und unabhängig voneinander einstellbar sind. Der Lenkluftring ist ebenfalls konstruktiv angepasst, damit das Zerstäubungssystem sowohl zur Innenlackierung als auch zur Außenlackierung bzw. zur Lackierung von Metallic- oder Effektlacken geeignet ist, wie noch detailliert beschrieben wird. Vorzugsweise ist der Lenkluftring so angepasst, dass sich das Zerstäubungssystem auch zur Applikation von Klarlack und Füller eignet.

Gemäß der Erfindung weist der Glockenteller eine ringförmig umlaufende Absprühkante mit einem vorgegebenen Außendurchmesser auf. Hierbei weist der Lenkluftring zur Abgabe der ersten Lenkluft einen ersten Lenkluftdüsenkranz mit mehreren ringförmig verteilt angeordneten Lenkluftdüsen auf, wobei der erste Lenkluftdüsenkranz einen bestimmten Durchmesser aufweist, der im Wesentlichen gleich dem Außendurchmesser der Absprühkante des Glockentellers ist, so dass die erste Lenkluft auf die Absprühkante des Glockentellers gerichtet ist. Dies ist vorteilhaft, weil die erste Lenkluft auf diese Weise ebenfalls zur Zerstäubung des von dem Glockenteller abgegebenen Sprühstrahls beitragen kann.

Darüber hinaus weist der Lenkluftring zur Abgabe der zweiten Lenkluft einen zweiten Lenkluftdüsenkranz mit mehreren ringförmig verteilt angeordneten Lenkluftdüsen auf, wobei der zweite Lenkluftdüsenkranz einen bestimmten Durchmesser aufweist, der im Wesentlichen gleich dem Außendurchmesser der Absprühkante des Glockentellers ist, so dass auch die zweite Lenkluft im Wesentlichen auf die Absprühkante des Glockentellers gerichtet ist und dadurch zur Zerstäubung des applizierten Beschichtungsmittels beitragen kann.

Es ist hierbei jedoch nicht erforderlich, dass der Durchmesser der beiden Lenkluftdüsenkränze exakt gleich dem Außendurchmesser der Absprühkante des Glockentellers ist. Vielmehr ist zwischen dem Außendurchmesser der Absprühkante des Glockentellers einerseits und dem Durchmesser der beiden Lenkluftdüsenkränze andererseits eine radiale Abweichung von bis zu ±1mm, ±2mm oder sogar ±3mm möglich.

Gemäß der Erfindung sind die Lenkluftdüsen des ersten Lenkluftdüsenkranzes axial zur Drehachse des Glockentellers ausgerichtet und geben die erste Lenkluft deshalb axial ab. Die Lenkluftdüsen des zweiten Lenkluftdüsenkranzes sind dagegen in dem bevorzugten Ausführungsbeispiel in Umfangsrichtung entgegen der Drehrichtung des Glockentellers ausgerichtet, so dass die zweite Lenkluft mit einem vorgegebenen Drallwinkel in Umfangsrichtung abgegeben wird. Die zweite Lenkluft ist also entgegen der Drehrichtung des Glockentellers angewinkelt, wodurch die Zerstäubungswirkung der zweiten Lenkluft zusätzlich verbessert wird.

Vorzugsweise beträgt der Drallwinkel der zweiten Lenkluft in Umfangsrichtung im Wesentlichen 55°. Die Erfindung ist jedoch hinsichtlich des Drallwinkels der zweiten Lenkluft nicht auf den exakten Wert von 55° beschränkt, sondern auch mit anderen Drallwinkeln realisierbar. Beispielsweise kann der Drallwinkel im Bereich von 40° bis 70° liegen, wobei ein Bereich von 50° bis 60° bevorzugt wird.

Ein Kerngedanke der Erfindung besteht darin, dass die Lenklüfte möglichst exakt auf die Absprühkante des Glockentellers auftreffen, um zu der Zerstäubung des applizierten Beschichtungsmittels beizutragen. Die gedrallte zweite Lenkluft legt jedoch zwischen den Lenkluftdüsen und der Absprühkante des Glockentellers einen größeren Weg zurück als die axial ausgerichtete erste Lenkluft. Die in Umfangsrichtung gedrallten Lenkluftdüsen weisen deshalb vorzugsweise gegenüber den axial ausgerichteten Lenkluftdüsen einen radialen Versatz nach innen auf, wobei der radiale Versatz in Abhängigkeit von dem Drallwinkel so bemessen wird, dass die gedrallte zweite Lenkluft exakt auf die Absprühkante des Glockentellers gerichtet wird. Beispielsweise kann der radiale Versatz zwischen den axial ausgerichteten Lenkluftdüsen und den in Umfangsrichtung gedrallten Lenkluftdüsen im Bereich von 0-1mm liegen. Auf diese Weise wird erreicht, dass sowohl die axial ausgerichtete erste Lenkluft als auch die gedrallte zweite Lenkluft exakt auf die Absprühkante des Glockentellers gerichtet sind.

Weiterhin ist es im Rahmen der Erfindung wünschenswert, dass sich die aus den einzelnen Lenkluftdüsen abgegebenen Lenkluftstrahlen beim Auftreffen auf die Absprühkante des Glockentellers aufgrund ihrer Strahlaufweitung in Umfangsrichtung überlappen oder zumindest lückenlos aneinander stoßen. Die Strahlaufweitung der einzelnen Lenkluftstrahlen ist deshalb vorzugsweise so bemessen, dass die benachbarten Lenkluftstrahlen an der Absprühkante des Glockentellers in Umfangsrichtung überlappen oder lückenlos aneinander stoßen

Hierbei ist zu beachten, dass die axial ausgerichtete erste Lenkluft bis zum Erreichen der Absprühkante des Glockentellers einen kürzeren Weg zurücklegt als die gedrallte zweite Lenkluft, die aus den in Umfangsrichtung gedrallten Lenkluftdüsen abgegeben wird. Die axial ausgerichteten Lenkluftdüsen weisen deshalb eine größere Düsenöffnung und/oder eine größere Strahlaufweitung auf als die in Umfangsrichtung gedrallten Düsenöffnungen, damit an der Absprühkante des Glockentellers trotz des kürzeren Wegs bis zu der Absprühkante die gewünschte Überlappung der benachbarten Lenkluftstrahlen gewährleistet ist.

In dem bevorzugten Ausführungsbeispiel der Erfindung weist der Lenkluftring an seiner Stirnseite eine umlaufende Ringmulde auf. Der Glockenteller weist hierbei an seiner Hinterseite eine ebenfalls ringförmig umlaufende Glockentellerhinterkante auf, die im montierten Zustand axial in die Ringmulde in dem Lenkluftring eintaucht, so dass der Glockenteller eine bestimmte axiale Einhausungstiefe aufweist. Eine derartige Anordnung ist beispielsweise aus DE 10 2006 057 596 bekannt, so dass der Inhalt dieser früheren Patentanmeldung der vorliegenden Beschreibung in vollem Umfang zuzurechnen ist, insbesondere hinsichtlich der konstruktiven Gestaltung der Ringmulde und der Glockentellerhinterkante.

Vorzugsweise sind die Glockentellerhinterkante und die Ringmulde mit einem bestimmten Krümmungsradius abgerundet, wobei der Krümmungsradius der Abrundung der Glockentellerhinterkante vorzugsweise kleiner ist als der Krümmungsradius der Abrundung der Ringmulde, was aus strömungstechnischen Gründen vorteilhaft ist. Beispielsweise kann der Krümmungsradius der Abrundung der Glockentellerhinterkante R=3,36mm betragen, während der Krümmungsradius der Abrundung der Ringmulde R=4mm ist. Die Erfindung ist jedoch hinsichtlich der Krümmungsradien der Abrundung der Glockentellerhinterkante bzw. der Ringmulde nicht auf die vorstehend exemplarisch genannten Werte beschränkt. Beispielsweise kann der Krümmungsradius der Abrundung der Glockentellerhinterkante im Bereich von 2mm-5mm und vorzugsweise im Bereich von 3mm-4mm liegen. Der Krümmungsradius der Abrundung der Ringmulde kann beispielsweise im Bereich von 2mm-5mm und vorzugsweise im Bereich von 3,5mm-4,5mm liegen.

Zwischen dem Glockenteller und dem Lenkluftring liegt hierbei ein Spalt mit einer bestimmten Spaltbreite. Problematisch ist hierbei, dass der rotierende Glockenteller in diesem Spalt einen Unterdruck erzeugt, wodurch Beschichtungsmittel und Schmutz in den Spalt hineingesaugt werden kann. Vorzugsweise nimmt die Spaltbreite des Spalts zwischen dem Lenkluftring und dem Glockenteller deshalb in Spaltlängsrichtung von außen nach innen zu. Zum Einen ist dies im normalen Betrieb des Zerstäubungssystems vorteilhaft, weil dadurch die störende Unterdruckerzeugung in dem Spalt verringert wird, so dass weniger Beschichtungsmittel in den Spalt hineingesaugt wird. Zum Anderen ist diese Spaltgeometrie beim Spülen vorteilhaft, da der Spalt auf diese Weise eine Düse bildet, welche die Spülwirkung verbessert.

Vorzugsweise ist die Spaltbreite des Spaltes zwischen dem Glockenteller und dem Lenkluftring größer als 0,5mm, 0,7mm oder sogar größer als 0,8mm, und kleiner als 5mm oder sogar kleiner als 4mm. Hierbei nimmt die Spaltbreite des Spaltes zwischen dem Glockenteller und dem Lenkluftring vorzugsweise in Spaltlängsrichtung von außen nach innen um mehr als 1mm oder sogar um mehr als 2mm zu, um den vorstehend erwähnten strömungstechnischen Vorteil zu erzielen.

In dem bevorzugten Ausführungsbeispiel der Erfindung weist das Zerstäubungssystem zum Antrieb des Glockentellers eine Turbine auf, die eine Glockentellerwelle antreibt, auf welcher der Glockenteller montiert ist. Hierbei ist der Lenkluftring vorzugsweise direkt an der Turbine bzw. dem Turbinengehäuse oder der Lagereinheit befestigt, insbesondere indem der Lenkluftring auf ein Außengewinde an dem Turbinengehäuse aufgeschraubt ist. Auf diese Weise wird sichergestellt, dass der Lenkluftring und die Glockentellerwelle exakt koaxial verlaufen. Dadurch wird eine radiale Fehlausrichtung zwischen der Glockentellerwelle und dem Lenkluftring verhindert, die im schlimmsten Fall zu einem Berührungskontakt zwischen dem Lenkluftring und der Glockentellerwelle führen könnte. Die Erfindung ist jedoch hinsichtlich der mechanischen Verbindung zwischen dem Lenkluftring und der Turbine bzw. der Lagereinheit nicht auf eine Schraubverbindung beschränkt, sondern auch mit anderen Verbindungsarten realisierbar.

Weiterhin ist zu erwähnen, dass der Lenkluftring vorzugsweise den Bereich der Glockentellerwelle zwischen dem Glockenteller und der Turbine vollständig ummantelt, so dass die Glockentellerwelle in diesem Bereich nicht frei liegt und deshalb weniger verschmutzungsanfällig ist.

Vorzugsweise ist der Außendurchmesser des Glockentellers an der Absprühkante im Wesentlichen gleich 52,4mm. Die Erfindung ist jedoch hinsichtlich des Außendurchmessers des Glockentellers nicht auf diesen exakten Wert beschränkt, sondern beispielsweise auch mit Außendurchmessern realisierbar, die im Bereich von 45mm-60mm liegen, wobei ein Bereich von 50mm-55mm bevorzugt ist.

Weiterhin weisen die gedrallten Lenkluftdüsen vorzugsweise einen Düsendurchmesser von im Wesentlichen 0,65mm oder 0,6mm auf, während der Düsendurchmesser der axial ausgerichteten Lenkluftdüsen vorzugsweise im Wesentlichen 0,7mm beträgt. Der Düsendurchmesser der gedrallten Lenkluftdüsen kann jedoch auch im Bereich von 0,5-0,9mm liegen, während der Düsendurchmesser der axial ausgerichteten Lenkluftdüsen im Bereich von 0,5mm-0,9mm liegen kann. Die Erfindung ist jedoch hinsichtlich des Düsendurchmessers nicht auf die vorstehend genannten Wertebereiche beschränkt, sondern in Abhängigkeit von der sonstigen Geometrie des Glockentellers auch mit anderen Werten realisierbar.

Ferner ist zu erwähnen, dass der Glockenteller in herkömmlicher Weise eine außenliegende Mantelfläche aufweist, die mit einem bestimmten Mantelflächenwinkel gegenüber der Drehachse des Glockentellers angewinkelt ist, wobei der Mantelflächenwinkel vorzugsweise 25° beträgt. Der Mantelflächenwinkel kann jedoch auch im Bereich von 5°-45° liegen, wobei ein Bereich von 20°-35° bevorzugt wird.

Darüber hinaus kann die Mantelfläche des Glockenteller strukturiert sein, beispielsweise durch eine konkave oder konvexe Formgebung oder durch umlaufende Rillen. Eine derartige Strukturierung der Glockentellermantelfläche ist beispielsweise in DE 10 2006 057 596 und EP 1 250 960 A2 beschrieben, so dass der Inhalt dieser Patentanmeldungen der vorliegenden Beschreibung in vollem Umfang zuzurechnen ist.

Darüber hinaus weist der Glockenteller vorzugsweise eine axiale Mantelflächenlänge von 12,75mm auf. Die Erfindung ist jedoch hinsichtlich der axialen Mantelfläche nicht auf diesen exakten Wert beschränkt, sondern beispielsweise auch mit axialen Mantelflächenlängen im Bereich von 5mm-25mm realisierbar, wobei ein Bereich von 10mm-15mm bevorzugt wird.

Ferner liegt zwischen den Lenkluftdüsen und der Absprühkante des Glockentellers vorzugsweise ein bestimmter Abstand in axialer Richtung. Einerseits führt ein zu großer axialer Abstand zwischen den Lenkluftdüsen und der Absprühkante des Glockentellers dazu, dass die Lenkluft beim Auftreffen auf die Absprühkante des Glockentellers bereits zuviel Strömungsenergie verloren hat und deshalb nicht mehr in befriedigendem Maße zur Zerstäubungswirkung beitragen kann. Andererseits führt ein zu geringer axialer Abstand zwischen den Lenkluftdüsen und der Absprühkante des Glockentellers dazu, dass sich kein homogener Luftstrahlkegel ausbilden kann, da die Strahlaufweitung aufgrund der Kürze der zur Verfügung stehenden Strecke nicht groß genug ist, so dass der Lenkluftstrahl den Sprühstrahl einfach durchdringt, ohne zu der gewünschen Zerstäubungswirkung (Strahlumlenkung) zu führen. Der axiale Abstand zwischen den Lenkluftdüsen und der Absprühkante des Glockentellers beträgt deshalb vorzugsweise 6,3mm. Die Erfindung ist jedoch hinsichtlich des axialen Abstandes zwischen den Lenkluftdüsen und der Absprühkante des Glockentellers nicht auf den vorstehend genannten exakten Wert beschränkt, sondern beispielsweise auch mit einem axialen Abstand im Bereich von 1mm-15mm realisierbar, wobei ein Bereich von 2mm-10mm und insbesondere von 3mm-5mm bevorzugt wird.

Ferner weist der erfindungsgemäße Glockenteller in herkömmlicher Weise eine Überströmfläche auf, die mit einem bestimmten Winkel gegenüber der Drehachse des Glockentellers geneigt ist. Vorzugsweise beträgt dieser Winkel im Wesentlichen 74°. Die Erfindung ist jedoch hinsichtlich des Neigungswinkels der Überströmfläche nicht auf den vorstehend genannten exakten Wert beschränkt, sondern auch mit Winkeln in einem Bereich von 50°-90° realisierbar, wobei ein Winkelbereich von 70°-80° bevorzugt wird.

Darüber hinaus kann der erfindungsgemäße Glockenteller wahlweise eine gerade oder eine gekrümmte Absprühkante aufweisen.

Vorzugsweise wird das Zerstäubungssystem darüber hinaus auch zur Applikation von Metalliclack oder sonstigen Effektlacken verwendet.

Darüber hinaus wird das erfindungsgemäße Zerstäubungssystem vorzugsweise auch zur Applikation von Füller und/oder Klarlack verwendet.

Die Drehzahl des Glockentellers wird hierbei vorzugsweise in Abhängigkeit von der jeweiligen Lackier- und Lackart (Füller, Basislack, Klarlack) angepasst, um ein gutes Lackierergebnis zu erreichen. So wird zur Innenlackierung von Kraftfahrzeugkarosseriebauteilen vorzugsweise eine Drehzahl im Bereich von 5.000min⁻¹-40.000min⁻¹ eingestellt, während bei der Außenlackierung eine Drehzahl im Bereich von 30.000min⁻¹-70.000min⁻¹ bevorzugt wird. Bei der Applikation von Metalliclack oder sonstigem Effektlack wird dagegen vorzugsweise eine Drehzahl im Bereich von 10.000min⁻¹-70.000min⁻¹ eingestellt.

Die applizierte Farbmenge kann hierbei im Bereich von 50ml/min bis 1.000ml/min und insbesondere im Bereich von 100ml/min-200ml/min liegen.

Ferner ist zu erwähnen, dass aus den gedrallten Lenkluftdüsen vorzugsweise ein Lenkluftstrom abgegeben wird, der im Bereich von 0Nl/min bis 700Nl/min liegt. Aus den axial ausgerichteten Lenkluftdüsen wird dagegen vorzugsweise ein Lenkluftstrom abgegeben, der im Bereich von 100Nl/min bis 800Nl/min liegt.

Andere vorteilhafte Weiterbildungen der Erfindung sind in den Unteransprüchen gekennzeichnet oder werden nachstehend zusammen mit der Beschreibung des bevorzugten Ausführungsbeispiels der Erfindung anhand der Figuren näher erläutert. Es zeigen:
- Figur 1: eine Querschnittsansicht eines erfindungsgemäßen Zerstäubungssystems mit einem Glockenteller, einem Lenkluftring und einer Turbine, die in einem Rotationszerstäuber eingesetzt werden,

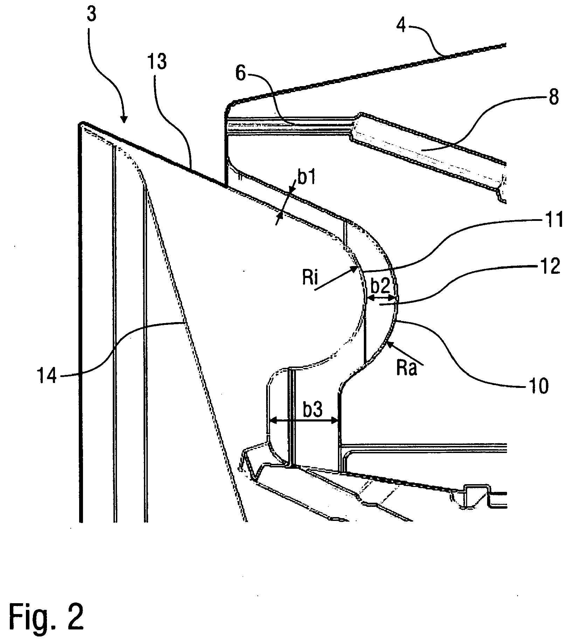

- Figur 2: eine Detailansicht aus Figur 1 im Bereich des Spalts zwischen dem Glockenteller und dem Lenkluftring,

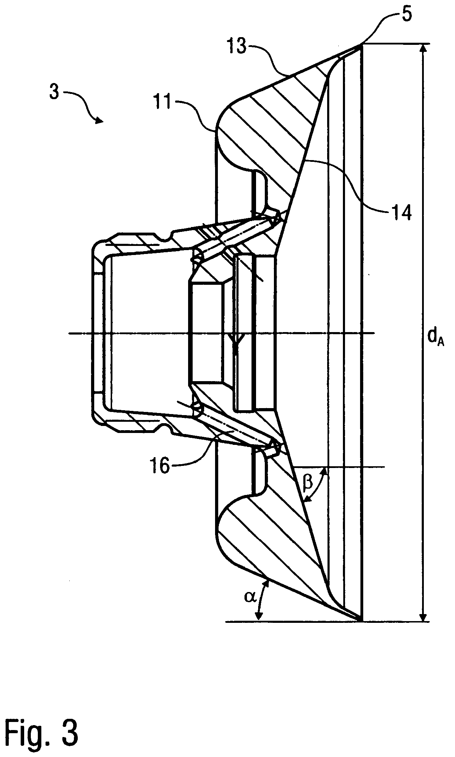

- Figur 3: eine Querschnittsansicht des Glockentellers aus Figur 1,

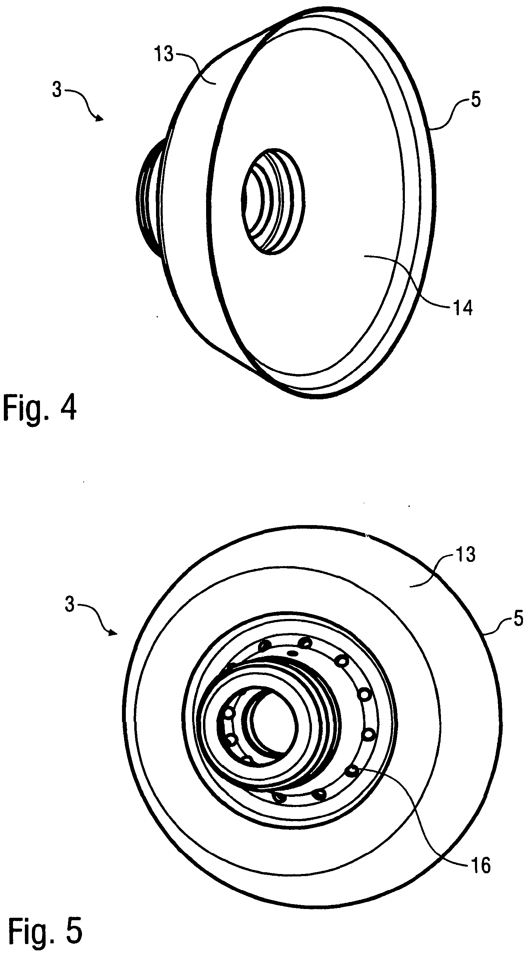

- Figur 4: eine frontseitige Perspektivansicht des Glockentellers aus Figur 1,
- Figur 5: eine rückwärtige Perspektivansicht des Glockentellers aus Figur 1,
- Figur 6: eine Frontansicht des Glockentellers aus Figur 1,
- Figur 7: eine Detailansicht der Querschnittsdarstellung des Glockentellers in Figur 3 im Bereich der Absprühkante,
- Figur 8: eine Querschnittansicht des Lenkluftrings entlang dem Schnitt B-B in Figur 10,
- Figur 9: eine Querschnittsansicht des Lenkluftrings entlang der Schnittlinie A-A in Figur 10,
- Figur 10: eine Rückansicht des Lenkluftrings aus Figur 1,
- Figur 11: eine Frontansicht des Lenkluftrings aus Figur 1, sowie
- Figur 12: eine Perspektivansicht des Lenkluftrings aus Figur 1.

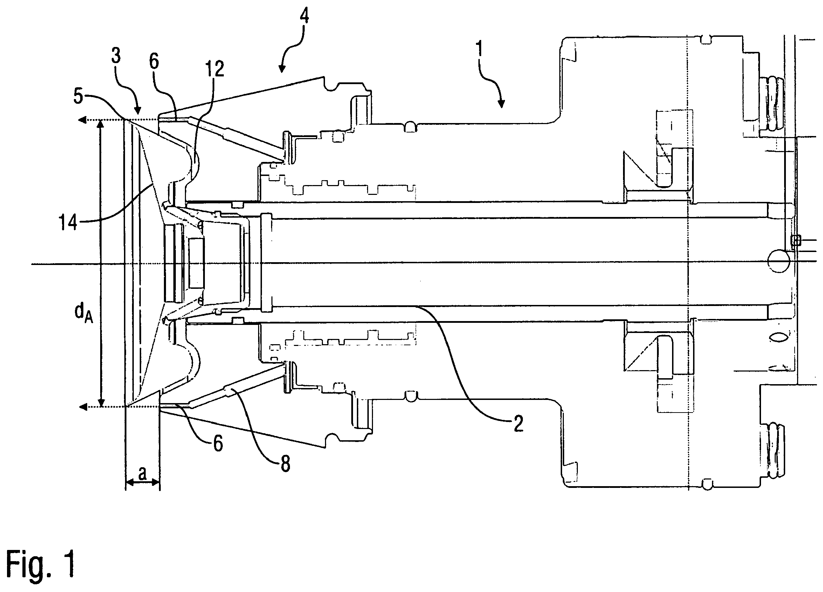

Die Zeichnung in Figur 1 zeigt ein erfindungsgemäßes Zerstäubungssystem, das in einem ansonsten herkömmlich ausgebildeten Rotationszerstäuber eingesetzt werden kann und sowohl zur Innenlackierung als auch zur Außenlackierung von Kraftfahrzeugkarosseriebauteilen geeignet ist. Bei den Kraftfahrzeugkarosserieteilen kann es sich beispielsweise um Kraftfahrzeugkarosserien oder Anbauteile (z.B. Stoßfänger, Spiegelgehäuse) handeln.

Darüber hinaus eignet sich das dargestellte erfindungsgemäße Zerstäubungssystem auch zur Applikation von Metalliclacken oder sonstigen Effektlacken sowie von Füller und Klarlack.

Hierzu weist das Zerstäubungssystem eine Druckluftturbine 1 auf, die weitgehend herkömmlich aufgebaut ist und eine Glockentellerwelle 2 antreibt. Anstelle der Druckluftturbine 1 kann jedoch auch eine andere Antriebseinheit verwendet werden, wie beispielsweise ein Elektromotor.

Auf die Glockentellerwelle 2 ist vorne ein neuartiger Glockenteller 3 aufgeschraubt, der noch detailliert beschrieben wird.

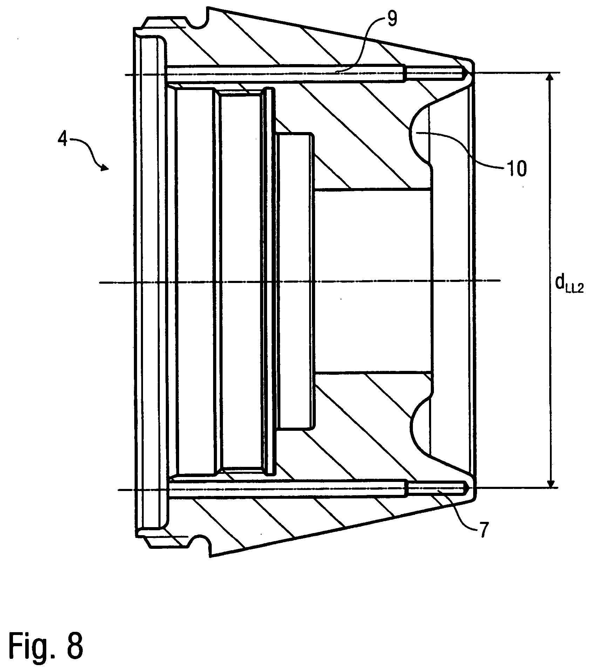

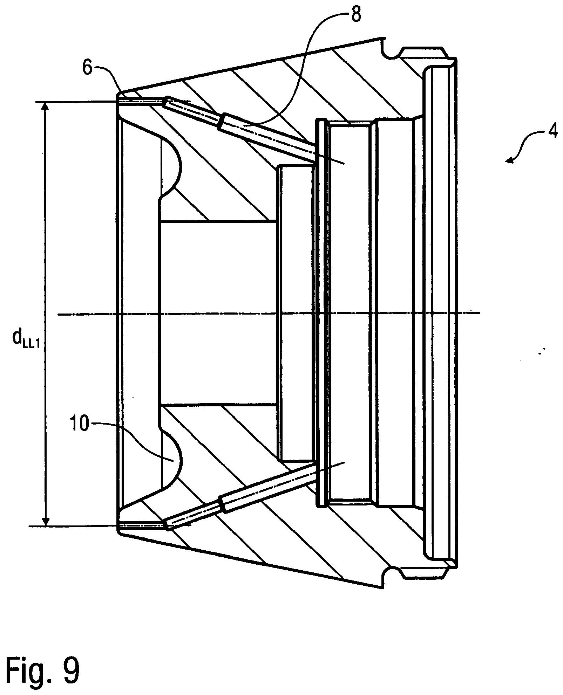

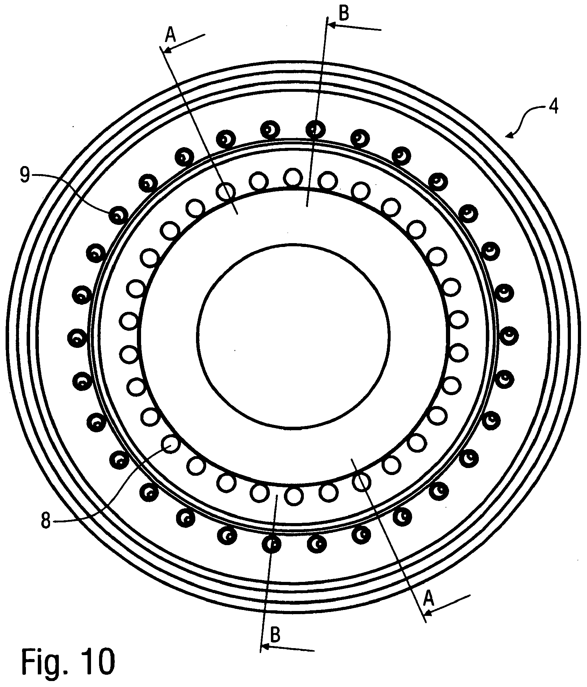

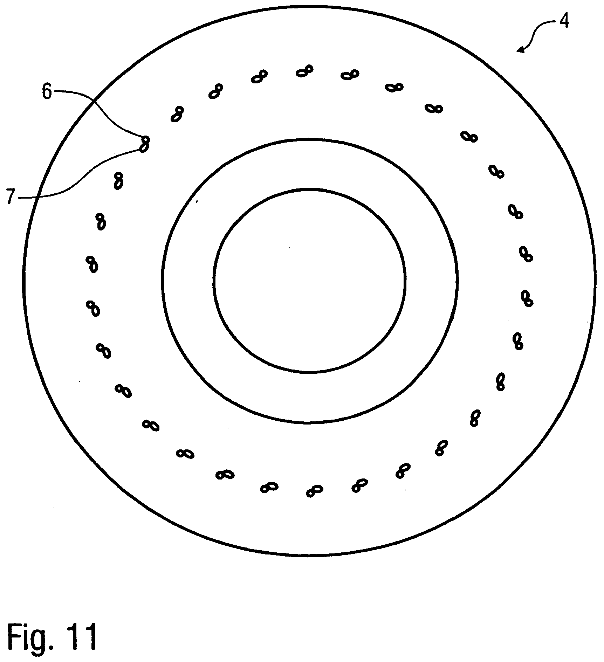

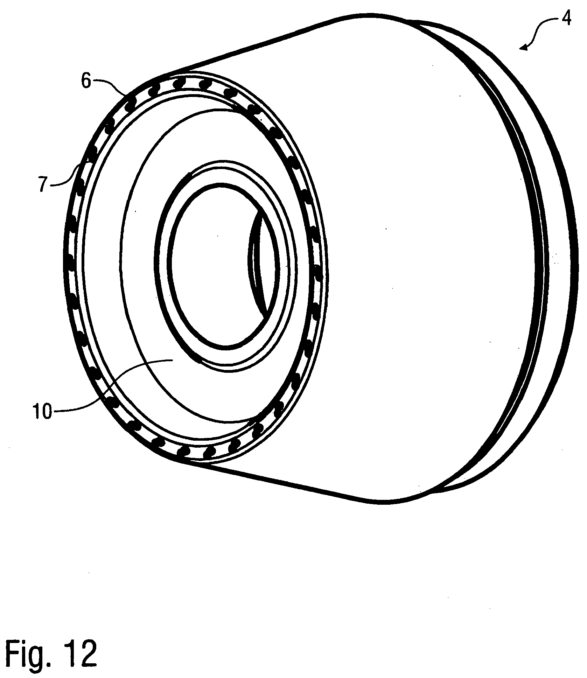

Darüber hinaus weist die Druckluftturbine 1 im vorderen Bereich an ihrer Mantelfläche ein Außengewinde auf, auf das ein Lenkluftring 4 aufgeschraubt ist, wobei der Lenkluftring 4 in den Figuren 8 bis 12 detailliert dargestellt ist. Vorteilhaft an dem direkten Aufschrauben des Lenkluftrings 4 auf die Druckluftturbine 1 ist die Tatsache, dass der Lenkluftring 4 und die Glockentellerwelle 2 exakt koaxial ausgerichtet werden. Dadurch wird eine radiale Fehlausrichtung zwischen dem Lenkluftring 4 und der Glockentellerwelle 2 verhindert, wodurch es im schlimmsten Fall zu einem Berührungskontakt zwischen dem Lenkluftring 4 und der Glockentellerwelle 2 kommen könnte.

Der Glockenteller 3 weist hierbei eine ringförmig umlaufende Absprühkante 5 mit einem Durchmesser d_{A}=52,4mm auf. Dieser Durchmesser des Glockentellers 3 ermöglicht in Kombination mit den anderen konstruktiven Merkmalen eine ausreichende Zerstäubung des applizierten Beschichtungsmittels auch bei hohen Ausflussmengen, wie sie beispielsweise bei Außenlackierungen von Kraftfahrzeugkarosseriebauteilen erforderlich sind. Bei einer Applikation von Metalliclacken ist dann jedoch eine zusätzliche bessere Zerstäubung erforderlich, wozu die von dem Lenkluftring 4 ausgeblasene Lenkluft dient, wie im Folgenden beschrieben wird.

So weist der Lenkluftring 4 zwei Lenkluftdüsenkränze auf, über die zwei getrennt voneinander steuerbare Lenklüfte auf den Sprühstrahl abgegeben werden können.

Zum einen ermöglichen die Lenklüfte eine Formung des von dem Glockenteller 3 abgegebenen Sprühstrahls, was an sich aus dem Stand der Technik bekannt ist.

Zum anderen tragen die Lenklüfte zur Zerstäubung des applizierten Beschichtungsmittels bei.

Der erste Lenkluftdüsenkranz weist eine Vielzahl von axial ausgerichteten Lenkluftdüsen 6 auf, die über den Umfang des Lenkluftrings 4 äquidistant verteilt angeordnet sind und eine erste Lenkluft axial auf die Absprühkante 5 des Glockentellers 3 abgeben, was zur Zerstäubung beiträgt.

Der zweite Lenkluftdüsenkranz weist eine Vielzahl von in Umfangsrichtung gedrallten Lenkluftdüsen 7 auf, die eine zweite Lenkluft auf die Absprühkante 5 des Glockentellers 3 abgeben, wobei die zweite Lenkluft entgegen der Drehrichtung des Glockentellers 3 angewinkelt ist und dadurch zur Zerstäubung des von dem Glockenteller 3 abgegebenen Beschichtungsmittels beiträgt. Der Drallwinkel der Lenkluftdüsen 7 beträgt hierbei 55°. Dies bedeutet, dass die zweite Lenkluft die Lenkluftdüsen 7 mit einem Winkel von 55° gegenüber der Längsachse in Umfangsrichtung angewinkelt verlässt.

Die beiden Lenkluftdüsenkränze weisen jeweils einen Durchmesser von im Wesentlichen 52mm auf, was dem Außendurchmesser der Absprühkante 5 des Glockentellers 3 entspricht. Dies ist vorteilhaft, weil die Lenklüfte dadurch relativ genau auf die Absprühkante 5 des Glockentellers 3 auftreffen und so eine gute Zerstäubungswirkung entfalten.

Trotz des Drallwinkels soll die aus den Lenkluftdüsen 7 austretende zweite Lenkluft möglichst exakt auf die Absprühkante 5 des Glockentellers 3 auftreffen, d.h. ohne eine radiale Überlappung oder einen radialen Abstand in Bezug auf die Absprühkante 5. Der zweite Lenkluftdüsenkranz mit den gedrallten Lenkluftdüsen 7 ist deshalb gegenüber dem ersten Lenkluftdüsenkranz mit den axial ausgerichteten Lenkluftdüsen 6 geringfügig in radialer Richtung nach innen versetzt, wobei der radiale Versatz entsprechend dem Drallwinkel der Lenkluftdüsen 7 so bemessen ist, dass die aus den gedrallten Lenkluftdüsen 7 austretende Lenkluft exakt auf die Absprühkante 5 des Glockentellers 3 auftrifft.

Die axial ausgerichteten Lenkluftdüsen weisen hierbei einen Düsendurchmesser von 0,7mm auf, während zwischen der Absprühkante 5 des Glockentellers 3 und den Lenkluftdüsen 6 ein axialer Abstand a=6,3mm liegt. Dies hat zur Folge, dass die aus den axial ausgerichteten Lenkluftdüsen 6 austretenden Lenkluftstrahlen an der Absprühkante 5 des Glockentellers 3 in Umfangsrichtung geringfügig überlappen.

Die gedrallten Lenkluftdüsen 7 weisen dagegen einen Düsendurchmesser von 0,65mm auf, was geringfügig kleiner ist als der Düsendurchmesser der axial ausgerichteten Lenkluftdüsen 6. Dies ist sinnvoll, da die aus den gedrallten Lenkluftdüsen 7 austretenden Lenkluftstrahlen bis zum Auftreffen auf die Absprühkante 5 des Glockentellers 3 einen größeren Weg zurücklegen und sich deshalb stärker erweitern. Die Verringerung des Düsendurchmessers der gedrallten Lenkluftdüsen 7 gegenüber den axial ausgerichteten Lenkluftdüsen 6 sorgt jedoch dafür, dass die aus den gedrallten Lenkluftdüsen 7 austretenden Lenkluftstrahlen an der Absprühkante 5 des Glockentellers 3 geringfügig in Umfangsrichtung überlappen, wie es auch für die Lenkluftstrahlen gilt, die aus den axial ausgerichteten Lenkluftdüsen 6 austreten.

Die vorstehend erwähnten Abmessungen ermöglichen vorteilhaft eine gute Zerstäubungswirkung der beiden Lenklüfte. So würde ein kleinerer axialer Abstand a zwischen den Lenkluftdüsen 6, 7 und der Absprühkante 5 des Glockentellers 3 dazu führen, dass die Lenklüfte zuviel Strömungsenergie hätten, so dass die Lenkluftstrahlen den Sprühstrahl einfach durchdringen würden ohne zur Zerstäubungswirkung wesentlich beizutragen. Ein größerer Abstand a zwischen den Lenkluftdüsen 6, 7 und der Absprühkante 5 des Glockentellers 3 hätte dagegen zur Folge, dass die Strömungsenergie der Lenklüfte bis zum Auftreffen auf die Absprühkante 5 bereits stark herabgesetzt wäre und deshalb keine befriedigende Zerstäubungswirkung mehr entfalten könnte.

Die beiden Lenkluftdüsenkränze mit den axial ausgerichteten Lenkluftdüsen 6 und den gedrallten Lenkluftdüsen 7 weisen jeweils getrennte Lenkluftzuführungen 8, 9 auf, die über den Zerstäuberflansch getrennt voneinander angesteuert werden können.

Darüber hinaus weist der Lenkluftring 4 an seiner Stirnseite eine koaxial umlaufende Ringmulde 10 auf, in die im montierten Zustand eine ebenfalls ringförmig umlaufende Glockentellerhinterkante 11 axial eintaucht. Der Lenkluftring 4 ummantelt also den axialen Bereich zwischen der Stirnfläche der Druckluftturbine 1 einerseits und dem Glockenteller 3, so dass die Glockentellerwelle 2 in diesem Bereich nicht frei liegt, wodurch Verschmutzungen der Glockentellerwelle 2 vermieden werden.

Zwischen der Glockentellerhinterkante 11 und der Ringmulde 10 in dem Lenkluftring 4 verläuft hierbei ein Spalt 12, der strömungstechnisch optimiert ist, wie im Folgenden beschrieben wird.

Zum Einen weist die Glockentellerhinterkante 11 eine Abrundung mit einem Krümmungsradius Ri=3,36mm auf, während die Ringmulde 10 eine Abrundung mit einem Krümmungsradius Ra=4mm aufweist. Dies bedeutet, dass der Krümmungsradius Ri der Glockentellerhinterkante 11 kleiner ist als der Krümmungsradius Ra der Ringmulde 10, was strömungstechnisch besonders günstig ist und der störenden Unterdruckbildung in dem Spalt 12 entgegenwirkt.

Zum Anderen weist der Spalt 12 zwischen der Glockentellerhinterkante 11 und der Ringmulde 10 eine Spaltbreite auf, die in Spaltlängsrichtung von außen nach innen zunimmt. So beträgt die Spaltbreite am Eingang des Spalts 12 b1=0,844mm. Am Scheitelpunkt der Glockentellerhinterkante 11 beträgt die Spaltbreite dann b2=0,915mm. Radial innerhalb der Glockentellerhinterkante 11 beträgt die Spaltbreite dann schließlich b3=3,19mm. Der Spalt 12 verengt sich also von innen nach außen. Im normalen Beschichtungsbetrieb wird dadurch der störenden Unterdruckbildung in dem Spalt 12 entgegengewirkt. Beim Spülen des Glockentellers 3 wirkt der sich verengende Spalt 12 dagegen als Düse und unterstützt damit die Spülwirkung an der Mantelfläche 13 des Glockentellers 3.

Der Glockenteller 3 weist hierbei eine Mantelfläche 13 auf, die gegenüber der Glockentellerwelle 2 um α=25° angewinkelt ist.

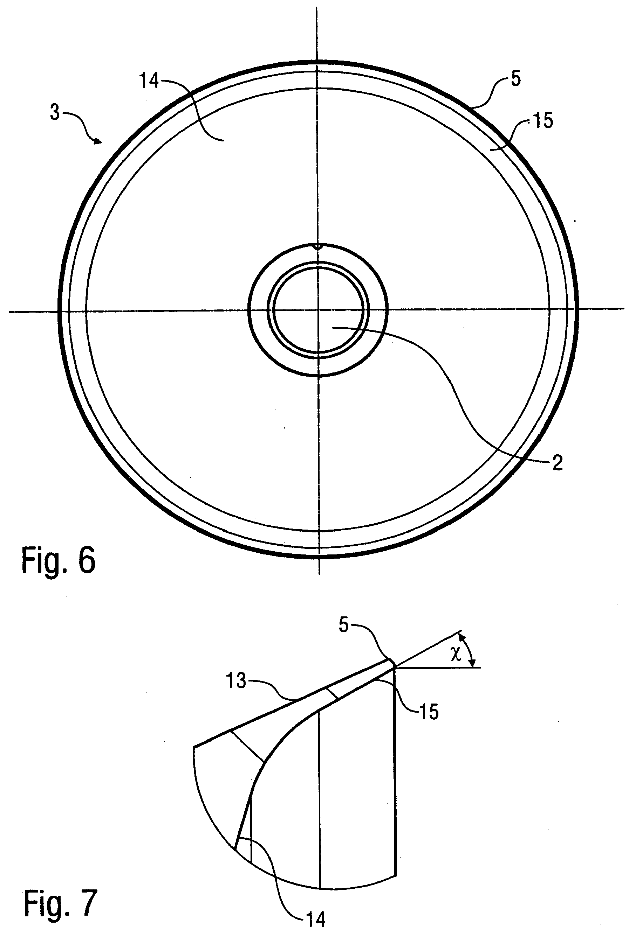

Weiterhin weist der Glockenteller 3 eine Überströmfläche 14 auf, die gegenüber der Glockentellerwelle 2 um β=74° geneigt ist. Im Bereich der Absprühkante 5 ist dagegen ein stärker angewinkelter Bereich 15 vorgesehen, der gegenüber der Glockentellerwelle 2 um χ=30° angewinkelt ist (vgl. Figur 7). Die vorstehend erwähnte gekrümmte Absprühkante 5 mit dem vergrößerten Winkel χ ist jedoch nicht zwingend erforderlich.

Ferner weist der Glockenteller 3 in herkömmlicher Weise Außenspülkanäle 16 auf, die aus dem Stand der Technik bekannt sind und deshalb nicht näher beschrieben werden müssen.

Die Erfindung ist nicht auf das vorstehend beschriebene bevorzugte Ausführungsbeispiel beschränkt. Vielmehr ist eine Vielzahl von Varianten und Abwandlungen möglich, die ebenfalls von dem Erfindungsgedanken Gebrauch machen. Schließlich ist zu erwähnen, dass sich das erfindungsgemäße Zerstäubungssystem nicht nur zur Beschichtung von Kraftfahrzeugkarosseriebauteilen eignet, sondern auch zur Lackierung anderer Bauteile verwendet werden kann.

### Bezugszeichenliste:

- 1: Druckluftturbine
- 2: Glockentellerwelle
- 3: Glockenteller
- 4: Lenkluftring
- 5: Absprühkante
- 6: Axial ausgerichtete Lenkluftdüsen
- 7: Gedrallte Lenkluftdüsen
- 8: Lenkluftzuführung
- 9: Lenkluftzuführung
- 10: Ringmulde
- 11: Glockentellerhinterkante
- 12: Spalt
- 13: Mantelfläche
- 14: Überströmfläche
- 15: Stärker angewinkelter Bereich
- 16: Außenspülkanäle
- b1: Spaltbreite
- b2: Spaltbreite
- b3: Spaltbreite
- Ri: Krümmungsradius der Glockentellerhinterkante
- Ra: Krümmungsradius der Ringmulde

## Patentansprüche

1. Zerstäubungssystem für einen Rotationszerstäuber zur Applikation eines Beschichtungsmittels, mit
a) einem drehbar gelagerten Glockenteller (3) zur Zerstäubung des Beschichtungsmittels und zur Abgabe eines Sprühstrahls des Beschichtungsmittels, wobei der Glockenteller (3) eine ringförmig umlaufende Absprühkante (5) mit einem vorgegebenen Außendurchmesser aufweist,
b) einem Lenkluftring (4) zur Abgabe einer ersten Lenkluft und einer zweiten Lenkluft zur Formung des von dem Glockenteller (3) abgegebenen Sprühstrahls, wobei die beiden Lenklüfte getrennte Lenkluftzuführungen (8, 9) aufweisen und unabhängig voneinander einstellbar sind, wobei
b1) der Lenkluftring (4) zur Abgabe der ersten Lenkluft einen ersten Lenkluftdüsenkranz mit mehreren ringförmig verteilt angeordneten Lenkluftdüsen (6) aufweist,
b2) der erste Lenkluftdüsenkranz einen bestimmten Durchmesser aufweist, der im Wesentlichen gleich dem Außendurchmesser der Absprühkante (5) des Glockentellers (3) ist, so dass die erste Lenkluft auf die Absprühkante (5) des Glockentellers (3) gerichtet ist,
b3) die Lenkluftdüsen (6) des ersten Lenkluftdüsenkranzes axial ausgerichtet sind und die erste Lenkluft axial abgeben,
b4) der Lenkluftring (4) zur Abgabe der zweiten Lenkluft einen zweiten Lenkluftdüsenkranz mit mehreren ringförmig verteilt angeordneten Lenkluftdüsen (7) aufweist,
b5) der zweite Lenkluftdüsenkranz einen bestimmten Durchmesser aufweist, der im Wesentlichen gleich dem Außendurchmesser der Absprühkante (5) des Glockentellers (3) ist, so dass die zweite Lenkluft auf die Absprühkante (5) des Glockentellers (3) gerichtet ist, und
b6) die Lenkluftdüsen (7) des zweiten Lenkluftdüsenkranzes in Umfangsrichtung entgegen der Drehrichtung des Glockentellers (3) ausgerichtet sind und die zweite Lenkluft mit einem vorgegebenen Drallwinkel in Umfangsrichtung abgeben,
c) wobei der Glockenteller (3) und der Lenkluftring (4) so ausgebildet sind, dass sich das Zerstäubungssystem zur Innenlackierung von Kraftfahrzeugkarosseriebauteilen und zur Außenlackierung von Kraftfahrzeugkarosseriebauteilen eignet,
**dadurch gekennzeichnet,**
d) **dass** die gedrallten Lenkluftdüsen (7) eine kleinere Düsenöffnung aufweisen als die axial ausgerichteten Lenkluftdüsen (6), und/oder
e) **dass** die gedrallten Lenkluftdüsen (7) eine kleinere Strahlaufweitung aufweisen als die axial ausgerichteten Lenkluftdüsen (6).

2. Zerstäubungssystem nach Anspruch 1, **dadurch gekennzeichnet, dass** der Glockenteller (3) und der Lenkluftring (4) so ausgebildet sind, dass sich das Zerstäubungssystem auch zur Applikation eines Metalliclacks oder eines sonstigen Effektlacks eignet oder zur Beschichtung von Kunststoffteilen eignet.

3. Zerstäubungssystem nach einem der vorhergehenden Ansprüche, **dadurch gekennzeichnet,**
a) **dass** die gedrallten Lenkluftdüsen (7) des zweiten Lenkluftdüsenkranzes gegenüber den axial ausgerichteten Lenkluftdüsen (6) des ersten Lenkluftdüsenkranzes mit einem bestimmten radialen Versatz nach innen angeordnet sind,
b) **dass** der radiale Versatz zwischen den gedrallten Lenkluftdüsen (7) und den axial ausgerichteten Lenkluftdüsen (6) in Abhängigkeit von dem Drallwinkel so bemessen ist, dass die gedrallte zweite Lenkluft auf die Absprühkante (5) des Glockentellers (3) gerichtet ist.

4. Zerstäubungssystem nach einem der vorhergehenden Ansprüche, **dadurch gekennzeichnet,**
a) **dass** die axial ausgerichtete erste Lenkluft eine Strahlaufweitung aufweist, die so bemessen ist, dass sich die Lenkluftstrahlen aus den unmittelbar benachbarten Lenkluftdüsen (6) an der Absprühkante (5) des Glockentellers (3) in Umfangsrichtung lückenlos aneinander grenzen oder in Umfangsrichtung überlappen, und/oder
b) **dass** die in Umfangsrichtung gedrallte zweite Lenkluft eine Strahlaufweitung aufweist, die so bemessen ist, dass sich die Lenkluftstrahlen aus den unmittelbar benachbarten Lenkluftdüsen (7) an der Absprühkante (5) des Glockentellers (3) in Umfangsrichtung lückenlos aneinander grenzen oder in Umfangsrichtung überlappen.

5. Zerstäubungssystem nach einem der vorhergehenden Ansprüche, **dadurch gekennzeichnet,**
a) **dass** der Lenkluftring (4) in seiner Stirnseite eine Ringmulde (10) aufweist, und
b) **dass** der Glockenteller (3) an seiner Hinterseite eine ringförmig umlaufende Glockentellerhinterkante (11) aufweist, die axial in die Ringmulde (10) in dem Lenkluftring (4) eintaucht, so dass der Glockenteller (3) eine bestimmte axiale Einhausungstiefe aufweist.

6. Zerstäubungssystem nach Anspruch 5,
**dadurch gekennzeichnet,**
a) **dass** die Glockentellerhinterkante (11) mit einem bestimmten Krümmungsradius (Ri) abgerundet ist, und
b) **dass** die Ringmulde (10) in dem Lenkluftring (4) mit einem bestimmten Krümmungsradius (Ra) abgerundet ist, und
c) **dass** der Krümmungsradius (Ri) der Abrundung der Glockentellerhinterkante (11) kleiner ist als der Krümmungsradius (Ra) der Abrundung der Ringmulde (10).

7. Zerstäubungssystem nach einem der vorhergehenden Ansprüche, **dadurch gekennzeichnet, dass** zwischen dem Glockenteller (3) und dem Lenkluftring (4) ein Spalt (12) mit einer bestimmten Spaltbreite (b1, b2, b3) liegt, wobei die Spaltbreite (b1, b2, b3) in Spaltlängsrichtung von außen nach innen zunimmt.

8. Zerstäubungssystem nach einem der vorhergehenden Ansprüche, **dadurch gekennzeichnet,**
a) **dass** zum Antrieb des Glockentellers (3) eine Turbine (1) vorgesehen ist, die eine Glockentellerwelle (2) antreibt, auf welcher der Glockenteller (3) montiert ist, und
b) **dass** der Lenkluftring (4) direkt an der Turbine (1) befestigt, insbesondere aufgeschraubt ist.

9. Zerstäubungssystem nach Anspruch 8, **dadurch gekennzeichnet, dass** der Lenkluftring (4) den Bereich der Glockentellerwelle (2) zwischen dem Glockenteller (3) und der Turbine vollständig ummantelt.

10. Zerstäubungssystem nach einem der vorhergehenden Ansprüche, **gekennzeichnet durch**
a) einen Auftragswirkungsgrad gemäß DIN EN 13966-1, der bei der Innenlackierung und bei der Außenlackierung und bei der Metalliclackierung größer ist als 55%, 60%, 65%, 70%, 75%, 80% oder 85%, und/oder
b) einen Gesamtfarbabstand AE* von weniger als ±1 bei der Innenlackierung und bei der Außenlackierung und bei der Metalliclackierung.

11. Lackieranlage zur Lackierung von Kraftfahrzeugkarosseriebauteilen mit einem Zerstäubungssystem nach einem der vorhergehenden Ansprüche zur Innenlackierung der Kraftfahrzeugkarosseriebauteile und zur Außenlackierung der Kraftfahrzeugkarosseriebauteile und vorzugsweise auch zur Lackierung von Metalliclacken und sonstigen Effektlacken.

12. Lackieranlage nach Anspruch 11, **gekennzeichnet durch** eine Lackierkabine, in der das Zerstäubungssystem die Innenlackierung der Kraftfahrzeugkarosseriebauteile und die Außenlackierung der Kraftfahrzeugkarosseriebauteile und vorzugsweise auch die Lackierung von Metalliclacken und sonstigen Effektlacken durchführt.

## Claims

1. Atomisation system for a rotary atomiser for the application of a coating agent, with
a) a rotatably mounted bell cup (3) for the atomisation of the coating agent and for discharging a spray jet of the coating agent, wherein the bell cup (3) has an annular circumferential spray edge (5) with a predetermined external diameter,
b) a shaping air ring (4) for discharging a first shaping air and a second shaping air for shaping the spray jet discharged by the bell cup (3), wherein the two shaping airs have separate shaping air inlets (8, 9) and are adjustable independently of one another,
wherein
b1) the shaping air ring (4) has a first shaping air nozzle annulus with a plurality of shaping air nozzles (6) arranged in an annularly distributed manner for discharging the first shaping air,
b2) the first shaping air nozzle annulus has a certain diameter which is essentially equal to the external diameter of the spray edge (5) of the bell cup (3), so that the first shaping air is directed onto the spray edge (5) of the bell cup (3),
b3) the shaping air nozzles (6) of the first shaping air nozzle annulus are orientated axially and axially discharge the first shaping air,
b4) the shaping air ring (4) has a second shaping air nozzle annulus with a plurality of shaping air nozzles (7) arranged in an annularly distributed manner for discharging the second shaping air,
b5) the second shaping air nozzle annulus has a certain diameter which is essentially equal to the external diameter of the spray edge (5) of the bell cup (3), so that the second shaping air is directed onto the spray edge (5) of the bell cup (3),
b6) the shaping air nozzles (7) of the second shaping air nozzle annulus are orientated in the circumferential direction against the direction of rotation of the bell cup (3) and discharge the second shaping air with a predetermined angle of twist in the circumferential direction,
c) the bell cup (3) and the shaping air ring (4) are designed in such a manner that the atomisation system is suitable for an interior painting of motor vehicle body components and for an exterior painting of motor vehicle body components,
**characterised in that**
d) the twisted shaping air nozzles (7) have a smaller nozzle opening than the axially orientated shaping air nozzles (6), and/or
e) the twisted shaping air nozzles (7) have a smaller jet expansion than the axially orientated shaping air nozzles (6).

2. Atomisation system according to Claim 1, **characterised in that** the bell cup (3) and the shaping air ring (4) are designed in such a manner that the atomisation system is also suitable for the application of a metallic paint or another effect paint or for the coating of plastic parts.

3. Atomisation system according to one of the preceding claims, **characterised**
a) **in that** the twisted shaping air nozzles (7) of the second shaping air nozzle annulus are arranged with a certain radial inward offset with respect to the axially orientated shaping air nozzles (6) of the first shaping air nozzle annulus,
b) **in that** the radial offset between the twisted shaping air nozzles (7) and the axially orientated shaping air nozzles (6) is dimensioned as a function of the angle of twist in such a manner that the twisted second shaping air is directed onto the spray edge (5) of the bell cup (3).

4. Atomisation system according to any one of the preceding claims, **characterised**
a) in that the axially orientated first shaping air has a jet expansion which is dimensioned in such a manner that the shaping air jets from the directly adjacent shaping air nozzles (6) adjoin one another without any gaps in the circumferential direction or overlap in the circumferential direction at the spray edge (5) of the bell cup (3), and/or
a) in that the first shaping air twisted in the circumferential direction has a jet expansion which is dimensioned in such a manner that the shaping air jets from the directly adjacent shaping air nozzles (7) adjoin one another without any gaps in the circumferential direction or overlap in the circumferential direction at the spray edge (5) of the bell cup (3).

5. Atomisation system according to any one of the preceding claims, **characterised**
a) **in that** the shaping air ring (4) has an annular depression (10) in its end face, and
b) **in that** the bell cup (3) has an annularly circumferential bell cup rear edge (11) on its rear side, which fits axially into the annular depression (10) in the shaping air ring (4), so that the bell cup (3) has a certain axial enclosure depth.

6. Atomisation system according to Claim 5, **characterised**
a) **in that** the bell cup rear edge (11) is rounded with a certain radius of curvature (Ri), and
b) **in that** the annular depression (10) in the shaping air ring (4) is rounded with a certain radius of curvature (Ra), and
c) **in that** the radius of curvature (Ri) of the rounding of the bell cup rear edge (11) is smaller than the radius of curvature (Ra) of the rounding of the annular depression (10).

7. Atomisation system according to any one of the preceding claims, **characterised in that** between the bell cup (3) and the shaping air ring (4), there is here a gap (12) with a certain gap width (b1, b2, b3), wherein the gap width (b1, b2, b3) increases inwardly from the outside in the gap longitudinal direction.

8. Atomisation system according to any one of the preceding claims, **characterised**
a) **in that** a turbine (1) is provided for driving the bell cup (3), which drives a bell cup shaft (2), on which the bell cup (3) is mounted, and
b) **in that** the shaping air ring (4) is fixed, particularly screwed, directly on the turbine (1).

9. Atomisation system according to Claim 8, **characterised in that** the shaping air ring (4) encases the region of the bell cup shaft (2) between the bell cup (3) and the turbine completely.

10. Atomisation system according to any one of the preceding claims, **characterised by**
a) an application efficiency according to DIN EN 13966-1 which is greater than 55%, 60%, 65%, 70%, 75%, 80% or 85% in the case of interior painting and in the case of exterior painting and in the case of metallic painting, and/or
b) a total colour difference ΔE* of less than ±1 in the case of interior painting and in the case of exterior painting and in the case of metallic painting.

11. Painting installation for the painting of motor vehicle body components with an atomisation system according to any one of the preceding claims for the interior painting of the motor vehicle body components and for the exterior painting of the motor vehicle body components and preferably also for the painting of metallic paints and other effect paints.

12. Painting installation according to Claim 11, **characterised by** a paint booth, in which the atomisation system carries out the interior painting of the motor vehicle body components and the exterior painting of the motor vehicle body components and preferably also the painting of metallic paints and other effect paints.

## Revendications

1. Système d'atomisation pour un atomiseur rotatif destiné à l'application d'un moyen de revêtement, avec
a) un plateau à cloche (3) supporté en rotation destiné à l'atomisation du moyen de revêtement et à la délivrance d'un jet de pulvérisation du moyen de revêtement, le plateau à cloche (3) présentant une arête de pulvérisation (5) périphérique de forme annulaire avec un diamètre extérieur prédéfini,
b) un anneau d'air de guidage (4) destiné à la délivrance d'un premier air de guidage et d'un deuxième air de guidage pour la formation du jet de pulvérisation délivré par le plateau à cloche (3), les deux airs de guidage présentant des amenées d'air de guidage (8, 9) séparées et pouvant être réglés indépendamment l'un de l'autre,
b1) l'anneau d'air de guidage (4) destiné à la délivrance du premier air de guidage présentant une première couronne de buses d'air de guidage avec plusieurs buses d'air de guidage (6) disposées de façon répartie en forme d'anneau,
b2) la première couronne de buses d'air de guidage présentant un diamètre défini qui est essentiellement égal au diamètre extérieur de l'arête de pulvérisation (5) du plateau à cloche (3) de telle sorte que le premier air de guidage est dirigé vers l'arête de pulvérisation (5) du plateau à cloche (3),
b3) les buses d'air de guidage (6) de la première couronne de buses d'air de guidage étant orientées axialement et délivrant le premier air de guidage axialement,
b4) l'anneau d'air de guidage (4) destiné à la délivrance du deuxième air de guidage présentant une deuxième couronne de buses d'air de guidage avec plusieurs buses d'air de guidage (7) disposées de façon répartie en forme d'anneau,
b5) la deuxième couronne de buses d'air de guidage présentant un diamètre défini qui est essentiellement égal au diamètre extérieur de l'arête de pulvérisation (5) du plateau à cloche (3) de telle sorte que le deuxième air de guidage est dirigé vers l'arête de pulvérisation (5) du plateau à cloche (3), et
b6) les buses d'air de guidage (7) de la deuxième couronne de buses d'air de guidage étant orientées dans la direction circonférentielle à l'inverse du sens de rotation du plateau à cloche (3) et délivrant le deuxième air de guidage avec un angle de vrille prédéfini dans la direction circonférentielle,
c) le plateau à cloche (3) et l'anneau d'air de guidage (4) étant constitués de telle sorte que le système d'atomisation convient à la peinture intérieure de composants de carrosserie automobile et à la peinture extérieure de composants de carrosserie automobile,
**caractérisé en ce que**
d) les buses d'air de guidage (7) vrillées présentent une ouverture de buses plus petite que les buses d'air de guidage (6) orientées axialement, et/ou
e) **en ce que** les buses d'air de guidage (7) vrillées présentent un évasement de jet plus petit que les buses d'air de guidage (6) orientées axialement.

2. Système d'atomisation selon la revendication 1, **caractérisé en ce que** le plateau à cloche (3) et l'anneau d'air de guidage (4) sont constitués de telle sorte que le système d'atomisation convient également pour l'application d'une peinture métallisée ou d'une autre peinture à effet ou pour le revêtement de parties en matière plastique.

3. Système d'atomisation selon l'une des revendications précédentes, **caractérisé en ce que**
a) par rapport aux buses d'air de guidage (6) orientées axialement de la première couronne de buses d'air de guidage, les buses d'air de guidage (7) vrillées de la deuxième couronne de buses d'air de guidage sont disposées avec un décalage radial défini vers l'intérieur,
b) **en ce que** le décalage radial entre les buses d'air de guidage (7) vrillées et les buses d'air de guidage (6) orientées axialement est dimensionné en fonction de l'angle de vrille de telle sorte que le deuxième air de guidage vrillé est dirigé vers l'arête de pulvérisation (5) du plateau à cloche (3).

4. Système d'atomisation selon l'une des revendications précédentes, **caractérisé en ce que**
a) le premier air de guidage orienté axialement présente un évasement de jet qui est dimensionné de telle sorte que les jets d'air de guidage en provenance des buses d'air de guidage (6) immédiatement voisines sont, au niveau de l'arête de pulvérisation (5) du plateau à cloche (3), mutuellement limitrophes en continu dans la direction circonférentielle ou se chevauchent dans la direction circonférentielle, et/ou
b) **en ce que** le deuxième air de guidage vrillé dans la direction circonférentielle présente un évasement de jet qui est dimensionné de telle sorte que les jets d'air de guidage en provenance des buses d'air de guidage (7) immédiatement voisines sont, au niveau de l'arête de pulvérisation (5) du plateau à cloche (3), mutuellement limitrophes en continu dans la direction circonférentielle ou se chevauchent dans la direction circonférentielle.

5. Système d'atomisation selon l'une des revendications précédentes,
**caractérisé en ce que,**
a) dans son côté frontal, l'anneau d'air de guidage (4) présente une dépression annulaire (10), et
b) **en ce que**, sur son côté arrière, le plateau à cloche (3) présente une arête arrière de plateau à cloche (11) périphérique de forme annulaire qui plonge axialement dans la dépression annulaire (10) dans l'anneau d'air de guidage (4) de telle sorte que le plateau à cloche (3) présente une profondeur d'enceinte axiale définie.

6. Système d'atomisation selon la revendication 5, **caractérisé en ce que**
a) l'arête arrière de plateau à cloche (11) est arrondie avec un rayon de courbure (Ri) défini, et
b) **en ce que** la dépression annulaire (10) dans l'anneau d'air de guidage (4) est arrondie avec un rayon de courbure (Ra) défini, et
c) **en ce que** le rayon de courbure (Ri) de l'arrondi de l'arête arrière de plateau à cloche (11) est plus petit que le rayon de courbure (Ra) de l'arrondi de la dépression annulaire (10).

7. Système d'atomisation selon l'une des revendications précédentes, **caractérisé en ce que,** entre le plateau à cloche (3) et l'anneau d'air de guidage (4), il y a un interstice (12) avec une largeur d'interstice (b1, b2, b3) définie, la largeur d'interstice (b1, b2, b3) augmentant de l'extérieur vers l'intérieur dans la direction longitudinale d'interstice.

8. Système d'atomisation selon l'une des revendications précédentes, **caractérisé en ce que**
a) pour l'entraînement du plateau à cloche (3), il est prévu une turbine (1) qui entraîne un arbre de plateau à cloche (2) sur lequel est monté le plateau à cloche (3), et
b) **en ce que** l'anneau d'air de guidage (4) est fixé directement sur la turbine (1), en particulier par vissage.

9. Système d'atomisation selon la revendication 8, **caractérisé en ce que** l'anneau d'air de guidage (4) enveloppe entièrement la zone de l'arbre de plateau à cloche (2) entre le plateau à cloche (3) et la turbine.

10. Système d'atomisation selon l'une des revendications précédentes, **caractérisé par**
a) un rendement d'application selon DIN EN 13966-1 qui est supérieur à 55 %, 60 %, 65 %, 70 %, 75 %, 80 % ou 85 % pour la peinture intérieure et pour la peinture extérieure et pour la peinture métallisée, et/ou
b) une différence de couleur globale ΔE* inférieure à ± 1 pour la peinture intérieure et pour la peinture extérieure et pour la peinture métallisée.

11. Installation de peinture destinée à la peinture de composants de carrosserie automobile avec un système d'atomisation selon l'une des revendications précédentes, destinée à la peinture intérieure des composants de carrosserie automobile et à la peinture extérieure des composants de carrosserie automobile et de préférence également à l'application de peintures métallisées et aux peintures à effet.

12. Installation de peinture selon la revendication 11, **caractérisée par** une cabine de peinture, dans laquelle le système d'atomisation réalise la peinture intérieure des composants de carrosserie automobile et la peinture extérieure des composants de carrosserie automobile et de préférence également l'application de peintures métallisées et d'autres peintures à effet.
